# EUROPÄISCHE PATENTANMELDUNG

(11) **EP 1 276 155 A2**
(43) Veröffentlichungstag der Anmeldung: **15.01.2003**
(21) Anmeldenummer: 02100779.4
(22) Anmeldetag: 03.07.2002
(51) Int. Cl.: H01L 27/00

(54) **Organische elektrolumineszente Anzeigenvorrichtung mit optischem Filter**

(30) Priorität: 05.07.2001 DE 10132699
(71) Anmelder: Philips Corporate Intellectual Property GmbH, 52066 Aachen (DE); Koninklijke Philips Electronics N.V., 5621 BA Eindhoven (NL)
(72) Erfinder: Bechtel, Helmut, c/o Philips Corporate Int.Prop., 52066 Aachen (DE); Opitz, Joachim, c/o Philips Corporate Int.Prop., 52066, Aachen (DE); Klein, Markus,c/o Philips Corporate Int.Prop., 52066, Aachen (DE); van Tongeren, Hein c/o Philips Corporate Int.Prop., 52066, Aachen (DE)
(74) Vertreter: Volmer, Georg, Dipl.-Ing.

(57) **Zusammenfassung**

Eine organische elektrolumineszente Anzeigevorrichtung, die eine Frontelektrodenkomponente, ein Gegenelektrodenkomponente, eine organische elektrolumineszente Komponente zwischen der Frontelektrodenkomponente und der Gegenelektrodenkomponente und eine optische Filterkomponente mit einem Kantenfilter zur Absorption von elektromagnetischer Strahlung mit einer Wellenlänge unterhalb einer Kantenwellenlänge λₖ und zur Transmission von elektromagnetischer Strahlung mit einer Wellenlänge oberhalb einer Kantenwellenlänge λₖ umfasst, hat einen verbesserten Kontrast bei starkem Umgsbungslicht.

## Beschreibung

Die Erfindung betrifft eine organische elektrolumineszente Anzeigevorrichtung (OLED), die eine Frontelektrodenkomponente (member), eine Gegenelektrodenkomponente, eine organische elektrolumineszente Komponente zwischen der Frontelektrodenkomponente und der Gegenelektrodenkomponente und eine optische Filterkomponente umfasst.

LEDs nach dem Stand der Technik sind in der Regel anorganische Halbleiterdioden, d.h. Dioden, deren Emittermaterial ein anorganischer Halbleiter, z. B. ZnS, Silicium, Germanium oder eine III-V-Halbleiter wie InP, GaAs, GaAlAs, GaP oder GaN mit entsprechenden Dotierungen ist.

Mit der Verfügbarkeit halbleitender organischer konjugierter Polymere und dem Nachweis ihrer Eignung zur Herstellung von lichtemittierenden Bauelementen begannen weltweit umfangreiche Arbeiten zur Entwicklung von organischen Elektrolumineszenzdioden und darauf aufbauend auch zu Displays. Im Gegensatz zu den anorganischen LEDs, deren Verwendung in höher auflösenden Displays nur bedingt und mit hohen Kosten möglich ist, wird in organischen Elektrolumineszenzdioden ein gewaltiges Potential für kleine und handliche Displays gesehen.

Organische Elektrolumineszenzdisplays haben im Gegensatz zu Flüssigkristalldisplays auch den Vorteil, dass sie selbstleuchtend sind und daher keine zusätzliche rückwärtige Beleuchtungsquelle benötigen.

Sie finden daher Anwendung, wo selbstleuchtende Anzeigevorrichtungen mit niedriger Versorgungsspannung und geringer Verlustleistung gefragt sind. Dazu zählen vor allem Displays für den mobilen Einsatz wie Handys, Organizer oder Anwendungen im Auto - vom Radio bis zum Navigationssystem.

Es ist wichtig für diese Anzeigevorrichtungen, die häufig bei hellem Umgsbungslicht benutzt werden, dass sie hell sind und trotzdem einen starken Kontrast haben. Eine Anzeigevorrichtung kann hell, aber trotzdem schlecht lesbar sein, weil der Kontrast zu schlecht ist. Der Kontrast ist eines der wichtigsten Kenndaten für die Gebrauchstauglichkeit der Anzeigevorrichtungen.

Kontrast ist definiert als das Verhältnis von emittiertem Signal zu dem insgesamt von der Anzeigevorrichtung ausgehenden Licht einschließlich des unerwünschten Lichtes. Unter praktischen Bedingungen dominiert in dem unerwünschten Licht das reflektierte Licht aus der Umgebung

Eine einfache Maßnahme zur Steigerung des Kontrastes besteht darin, vor die Anzeigevorrichtung eine über den gesamten Spektralbereich absorbierende Filterschicht zu setzen. Auf diese Art und Weise kann der Kontrast der Anzeigevorrichtung beliebig erhöht werden. Allerdings muss die Intensität des erzeugten Lichtes ebenfalls erhöht werden, um die erwünschte Luminanz der Anzeigevorrichtung zu erhalten. Das geht zu Lasten von deren Effizienz und der Lebensdauer.

Das reflektierte Licht kann entweder spiegelnd oder diffus sein. Spiegelnde Reflexe sind besonders lästig, weil der Betrachter das Anzeigebild überlagert mit dem spiegelnd reflektierten Bild der störenden Lichtquelle sieht. Das licht der Spiegelung ist in der Reflexionsrichtung konzentriert und mindert den Kontrast des Bildschirms im Blickwinkel der Reflexionsrichtung. Diffus reflektiertes Licht überlagert das Bildschirmbild mit einer Trübung, die den Kontrast mindert, die sichtbare Grauskala einengt und dadurch die sichtbare Information durch den Bildschirm verringert.

Um den Kontrast von organischen elektrolumineszenten Anzeigevorrichtung zu steigern, wurden bereits verschiedene Anordnungen mit Interferenz- und Polarisationsfiltern vorgeschlagen.

Beispielsweise beschreibt WO 0106816 ein organisches elektrolumineszentes Bauteil mit einer Frontelektrode, die im wesentlichen transparent für elektrolumineszentes Licht ist, mit eine Gegenelektrode, die im wesentlichen transparent für Umgebungslicht ist und mit einer optischen Interferenzkomponente zur Passivierung des elektrolumineszenten Bauteils und zur Reduktion der Reflexion des Umgebungslichtes hinter der Gegenelektrode.

Überraschenderweise wurde gefunden, dass die Reduktion der Reflexion des Umgebungslichtes durch die optische Interferenzkomponente hinter den Erwartungen zurückbleibt.

Es ist eine Aufgabe der vorliegenden Erfindung eine organische elektrolumineszente Anzeigevorrichtung mit verbessertem Kontrast zur Verfügung zu stellen.

Erfindungsgemäß wird die Aufgabe gelöst durch eine organische dektrolumineszente Anzeigevorrichtung, die eine Frontelektrodenkomponente, ein Gegenelektrodenkomponente, eine organische elektrolumineszente Komponente zwischen der Frontelektrodenkomponente und der Gegenelektrodenkomponente und eine optische Filterkomponente mit einem Kantenfilter zur Absorption von elektromagnetischer Strahlung mit einer Wellenlänge unterhalb einer Kantenwellenlänge λₖ und zur Transmission von elektromagnetischer Strahlung mit einer Wellenlänge oberhalb einer Kantenwellenlänge λₖ umfasst.

Der Erfindung liegt die Erkenntnis zugrunde, dass ein Teil des Umgebungslichts von der organischen elektrolumineszenten Komponente der Anzeigevorrichtung absorbiert wird und mit einer veränderten längeren Wellenlänge wieder emittiert wird. Dadurch sind optische Filter, wie Interferenzfilter und auch Polarisationsfilter, die am besten mit kohärentem Licht in einem schmalen Wellenlängenbereich arbeiten, in ihrer Wirkung eingeschränkt.

Das erfindungsgemäß verwendete Kantenfilter dagegen absorbiert die Strahlung aus dem Umgebungslicht, die in der organischen elektrolumineszenten Komponenten zur Emission von Licht führt.

Es ist bevorzugt, dass die Kantenwellenlänge λₖ 500 nm beträgt.

Es ist auch bevorzugt, dass die elektrolumineszente Komponente ein konjugiertes Leiterpolymer vom Poly(para-phenylen)-Typ (LPPP) enthält.

Diese konjugierten Leiterpolymere absorbieren im blauen Bereich des elektromagnetischen Spektrums und emittieren im grün-gelben Bereich des elektromagnetischen Spektrum, in dem auch die Augenempfindlichkeit ihr Maximum hat. Für grün-gelb emittierende Anzeigevorrichtungen ist es deshalb schwierig, einen hohen Kontrast zu erreichen. Organische elektrolumineszente Anzeigevorrichtungen mit einem konjugierten Leiterpolymer vom Poly(para-phenylen)-Typ (LPPP) als elektrolumineszenter Komponente profitieren besonders von der Verwendung eines Kantenfilters mit einer Kantenwellenlänge λₖ = 500 nm.

Nach einer bevorzugten Ausführungsform der Erfindung enthält das Kantenfilter einen gelben Farbstoff oder ein gelbes Farbpigment.

Bevorzugt sind gelbe Farbstoffe ausgewählt aus der Gruppe der gelben Farbstoffe mit dem C.I.-Index Solvent Yellow25, Solvent Yellow83:1, Solvent Yellow93, Solvent Yellow98, Solvent Yellow 114, Solvent Yellow 133, Solvent Yellow 163 und Solvent Yellow 179.

Es können auch gelbe Farbpigmente aus der Gruppe der gelben Farbpigmente mit dem C.I. Index Pigment Yellow 13, Pigment Yellow 17, Pigment Yellow 53, Pigment Yellow 74, Pigment Yellow 83, Pigment Yellow 110, Pigment Yellow 120 und Pigment Yellow 151 bevorzugt sein.

Nach einer Ausführungsform der Erfindung umfasst die optische Filterkomponente zusätzlich ein Polarisationsfilter.

Nach einer Ausführungsform der Erfindung umfasst die optische Filterkomponente zusätzlich ein Interferenzfilter.

Besonders bevorzugt ist ein Metall-Dielektrikum-Interferenzfilter, weil nur wenige zusätzliche Schichten für dessen Aurbau notwendig sind.

Nachfolgend wird die Erfindung anhand einer Figur weiter erläutert.

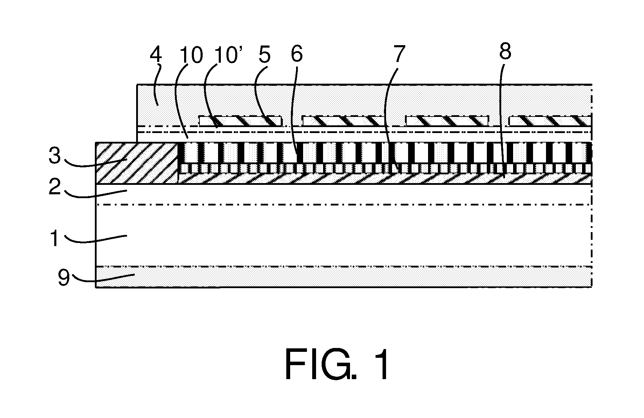

Fig 1 zeigt den schematischen Aufbau einer organischen elektrolumineszenten Anzeigevorrichtung

Eine organische elektrolumineszentes Anzeigevorrichtung nach der Erfindung umfasst eine Frontelektrodenkomponente, ein Gegenelektrodenkomponente, eine organische elektrolumineszente Komponente zwischen der Frontelektrodenkomponente und der Gegenelektrodenkomponente und einen Kantenfilter zur Absorption von elektromagnetischer Strahlung mit einer Wellenlänge unterhalb einer Kantenwellenlänge λₖ und zur Transmission von elektromagnetischer Strahlung mit einer Wellenlänge oberhalb einer Kantenwellenlänge λₖ umfasst.

Typischerweise besteht eine derartige Anzeigevorrichtung aus einem Schichtverbund von übereinander und teilweise nebeneinander aufgetragenen Einzelschichten. Für den Aufbau kommen alle dem Fachmann bekannten Schichtstrukturen und Materialien für diese Schichten in Frage. Üblicherweise enthalten die OLEDs eine elektrolumineszierende Schicht zwischen einer positiven Elektrode als Frontelektrode und einer negativen Elektrode als Gegenelektrode, wobei eine oder beide Elektroden transparent und/oder segmentiert sein können. Zusätzlich können zwischen der elektrolumineszierenden Schicht und der positiven Elektrode eine oder mehrere Elektroneninjektions- und/oder Elektronentransportschichten angeordnet werden. Ebenso können zwischen der elektrolumineszierenden Schicht und der negativen Elektrode eine oder mehrere Löcherinjektions- und/oder Löchertransportschichten angeordnet werden

Dieser Schichtverbund kann auf einem Substrat aus Glas, Quarz, Keramik, Kunstharz oder einer durchsichtigen, flexiblen Plastikfolie angeordnet sein. Geeignete Kunstharze sind z. B. Polyimide, Polyethylenterephtalate und Polytretrafluoroethylene.

Die elektrolumineszente Schicht ist zwischen zwei Elektrodenschichten angeordnet.

Die negative Elektrode liefert Elektronen, die sich mit den von der positiven Elektrode ausgehenden Löchern in der organischen elektrolumineszenten Schicht zu Excitonen vereinigen und bei der Rekombination Photonen ausstrahlen.

Wenigstens eine der Elektrodenschichten sollte transparent oder wenigstens transluzent sein. Üblicherweise ist die positive Elektrode aus einem nichtstöchiometrischem oder dotierten Zinnoxid, zB. ITO, oder einem Metall mit hoher Austrittsarbeit, z. B. Gold oder Silber hergestellt. Diese Elektrodenmaterialien können leicht als transparente Schichten hergestellt werden. Besonders ITO ist geeignet, aufgrund der Tatsache, dass es gute elektrische Leitfähigkeit hat und transparent ist.

Ebenso kann eine Schicht aus einem leitfähigen Polyanilin oder Poly-3,4-ethylen dioxythiophen allein oder zusammen mit einer ITO-Schicht als transparente positive Elektrode verwendet werden.

Die negative Elektrode, die Elektronen in die organische elektrolumineszente Schicht injiziert, soll eine niedrige Austrittsarbeit haben. Geeignet als Material für die negative Elektrode sind z. B. Indium, Aluminium, Calcium, Barium oder Magnesium. Wenn die negative Elektrode aus dem reaktiven Barium gefertigt wird, empfiehlt es sich, diese Elektrodenschicht mit einer Schutzschicht aus einem Epoxyharz oder einem inerten Metall zu bedecken. Diese Schichten haben den Vorteil, dass sie nicht so stark reflektieren, wie metallische Schichten

Als organische elektrolumineszente Komponente für die Anwendung in organischen LEDs haben sich aromatische, konjugierte Leiterpolymere vom Poly(para-phenylen)-Typ (LPPPs), die chemisch den Oligo- oder Polyphenylen ähnlich sind, als besonders geeignet herausgestellt. IPPPs weisen eine durchgehende Kette von konjugierten Doppelbindungen auf. Besonders geeignet sind z. B. lösliche Polyphenylenethylenvinylene und lösliche Polythiophene, insbesondere Polyphenylvinylene, die am Phenylring in 2- und 5-Position wieter mit Alkyl- oder Alkoxy-Resten substituiert sind. Derartige Polymere sind leicht verarbeitbar und ergeben Schichten mit amorpher Struktur. Beispiele für geeignete Polyphenylenvinyle sind Poly(2-methyl-5-(n-dodecyl)-p-Phenylenvinylen, Poly(2-methyl-5-(3,5,dimethyloctyl)-p-Phenylenvinylen, Poly(2-melhyl-5-(4,6,6,-trimethylheptyl)-p-Phenylenvinylen, Poly(2-methoxy-5-dodecyloxy-p-Phenylenvinylen und Poly(2-methoxy-5-(ethylhexyloxy)-p-Phenylenvinylen (MEH-PPV).

LPPPs zeigen neben Elektrolumineszenz auch Photolumineszenz. Die Leiterpolymere haben ein charakteristisches Absorptionsspektrum mit einer scharfen Absorptionskante und einer ausgsprägten vibronischen Feinstruktur. Die Photolumineszenz der LPPPS ist durch eine zur Absorption achsensymmetrischen Photolumineszenz (PL) gekennzeichnet, wobei eine Stoke-Verschiebung in der Größenordnung von 150 cm⁻¹ auftritt.

Deutlich besser als organische dektrolumineszente Anzeigevorrichtung mit einer einzigen Elektrolumineszenzschicht funktionieren Anzeigevorrichtungen, die zwei verschiedene Elektrolumineszenzschichten enthalten. Eine Schicht transportiert Löcher effektiv, z. B. PPV, eine Schicht transportiert Elektronen effektiv, z. B. Oxadiazol. Dadurch können nun Löcher und Elektronen leichter rekombinieren.

Besonders vorteilhaft für den Transport der positiven Ladungsträger ist Polyethylendioxythiophen PEDOT und Polyethylendioxythiophen-Polystyrensulfonat PEDOT-SS. Besonders vorteilhaft wird für den Transport der positiven Ladungsträger auch 4,4',4"-Tris[N-(1-naphtyl)-N--phenyl-amino]-triphenylamin zusammen mit Hydroxychinolin-Aluminium-III-Salz Alq₃ als Emissions- und Elektronentransportmaterial eingesetzt.

Die erfindungsgemäße Anzeigevorrichtung enthält einen Kantenfilter, der als Langpassfilter für Licht mit einer Wellenlänge λₖ von 500 nm ausgelegt ist. Er hat im Bereich unterhalb der Kantenwellenlänge von 500 nm eine niedrige Transmission (Sperrbereich) und im Bereich oberhalb der Kantenwellenlänge eine hohe Transmission (Passbereich). Bevorzugt ist der Transmission des Kantenfilters im Maximum der emittierten Strahlung mindestens um den Faktor 10 größer als die Transmission im Maximum der absorbierten Strahlung der organischen dektrolumineszierenden Komponenten

Die Kantenwellenlänge des Filters ist mit λₖ ≤ 500 nm der Wellenlänge der maximalen Emission der elektrolumineszierenden Schicht angepasst.

Fig. 1 zeigt eine organische elektrolumineszente Anzeigevorrichtung mit Kantenfilter.

Sie umfasst ein Glassubstrat 1, eine haftungsvermittelnde Schicht aus SiO₂ 2, eine Anode 8 aus ITO mit Kontaktanschlüssen 3, eine Passivierungsschicht aus Polyimid 4, eine elektrolumineszente Schicht 7 aus PDOT, eine zweite elektrolurnineszente Schicht 6 aus PPV, eine Kathode aus AI 5 mit einem Mdall-Didektrikum-Filter aus Barium 10 und ITO 10' und einen Kantenfilter 9.

Der Kantenfilter liegt vor der elektrolumineszenten Schicht, so dass die von der elektrolumineszenten Schicht ausgehende Strahlung den Kantenfilter passieren muss. Der Spektralbereich des vom Kantenfilter durchgelassenen Lichtes entspricht im wesentlichen der von der elektrolumineszenten Schicht ausgesandten Strahlung, so dass diese im wesentlichen ohne Intensitätsverlust den Kantenfilter durchdringt. Von außen eindringendes Umgebungslicht passiert den Kantenfilter, bevor es auf die reflektierenden Schichten der Anzeigevorrichtung auftrifft und dort reflektiert wird. Somit trifft nur Licht der Wellenlänge auf die Anzeigevorrichtung, die diese selber emittiert, wodurch die Reflexion des Umgebungslichtes stark gemindert wird.

Der Kantenfilter enthält ein gelbes Pigment oder einen gelben Farbstoff gleichmäßig verteilt oder gelöst in einem Träger, oder auf einen Träger aufgetragen. Geeignete Träger sind sowohl Glas als auch optisch transparente Kunstharze, z. B. Polyester, Polyacrylate, Polymethylmetacrylate, Polyolefine, Polycarbonate, Polystyrole u.ä. Von den Polyestern sind Polyethylenterephtalate und Polybutylenterephtalate besonders geeignet.

Der Kantenfilter kann als selbsttragende Folie oder als Dünnfilmbeschichtung ausgebildet sein. Er kann in einer beliebigen Stelle der organischen elektrolumineszenten Anzeigevorrichtung vor der elektrolumineszenten Schicht angeordnet sein. Bevorzugt hat eine selbsttragende Folie eine Dicke von 100 µm bis 1000 µm und eine Dünnfilmbeschichtung eine Dicke von 100 nm bis 1000 nm.

Der Träger kann auch ein Klarlack, z.B. ein Acrylharz-Klarlack oder eine Urethan-Klarlack, oder eine Kunstharzbeschichtung sein. Der als Kantenfilter wirkende Klarlack oder Kunstharzbeschichtung kann auf eine der Schichten der organischen dektrolumineszenten Anzeigevorrichtung vor der elektrolumineszenten Schicht aufgetragen werden.

Als besonders geeignete gelbe Pigmente haben sich transparente Monoazogelbpigmente, Diarylgelbpigmenteund gelbe Disazokondensationspigmente, die sich durch ihre Lichtechtheit auszeichne, erwiesen. Transparenz wird bei Pigmenten z.B. durch eine Korngröße < 200 nm erreicht.

In Tab. 1 und Tab.2 sind geeignete gelbe Farbstoffe und Farbpigmente angegeben.

**Tab. 1:**

| Gelbe Farbstoffe | | |
|---|---|---|
| Farbindex | Handelsname | Hersteller |
| Solvent Yellow 25 | Orasol Yellow 3R | Ciba-Geigy Corp. |
| Solvent Yellow 83:1 | Savinyl Yellow RLS | Cariant |
| Solvent Yellow 93 | Sandoplast Yellow 3G | Cariant |
| Solvent Yellow 98 | Hostasol Yellow 3G | Cariant |
| Solvent Yellow 114 | Sandoplast Yellow 2G | Cariant |
| Solvent Yellow 133 | Polysynthren Yellow GG | Cariant |
| Solvent Yellow 163 | Oracet Yellow 8GF | Ciba-Geigy Corp. |
| Solvent Yellow 179 | Macrolex Yellow 6G | Bayer |

| Gelbe Pigmente | | |
|---|---|---|
| Farbindex | Handelsname | Hersteller |
| Pigment Yellow 13 | Irgalite Yellow | Ciba-Geigy Corp. |
| Pigment Yellow17 | Graphtol Yellow GG | Cariant |
| Pigment Yellow 53 | Irgacolor Yellow 10401 | Ciba-Geigy Corp. |
| Pigment Yellow 74 | Unispeise Yellow | Ciba-Geigy Corp. |
| Pigment Yellow 83 | PV Fast Yellow HR | Cariant |
| Pigment Yellow 83 | Microlith Yellow | Ciba-Geigy Corp. |
| Pigment Yellow 110 | Chromophtal Yellow | Ciba-Geigy Corp. |
| Pigment Yellow 120 | PV Fast Yellow H2G | Cariant |
| Pigment Yellow 151 | Permajet Yellow H4G | Cariant |

Das gelbe Pigment oder der gelbe Farbstoff lässt alle elektromagnetische Strahlung mit einer Wellenlänge oberhalb von 500 nm passieren und absorbiert Strahlung mit einer Wellenlänge unterhalb von 500 nm.

Die Anzeigevorrichtung nach der Erfindung kann weiterhin optische Filterkomponenten enthalten, die die Spiegelungen innerhalb der Anzeigevorrichtung unterdrücken. Diese Spiegelungen entstehen einerseits an den Grenzflächen zwischen den Schichten der Anzeigevorrichtung, die mit unterschiedliche Brechungsindizes haben, andererseits an der metallischen Kathode, die wie ein metallischer Spiegel wirkt.

Um diese spiegelnden Reflexionen zu unterdrücken, kann die Anzeigevorrichtung einen Polarisationsfilter bekannter Bauart z. B. einen Zirkularpolarisationsfilter enthalten. Ein einfacher Zirkularpolarisationsfilter besteht aus einem Linearpolarisator und einem λ/4-Plättchen (quarter wave plate). Der Zirkularpolarisationsfilter ist so in die Anzeigevorrichtung eingebaut, dass der Lichtreflex zuerst den Linearpolarisator trifft und dann das λ/4-Plättchen passiert. Wenn der Lichtreflex von der Anzeigevorrichtung gespiegelt wird, wird das λ/4-Plättchen zweimal durchlaufen, wodurch das linear polarisierte Licht um 90° gegenüber der ursprünglichen Richtung gedreht wird. Das Resultat ist, dass der Linearpolarisator den gespiegelten Lichtreflex absorbiert.
Die Anzeigevorrichtung kann weiterhin einen Interferenzfilter, wie sie aus dem Stand der Technik z. B. EP0272760 bekannt sind, enthalten. Beispielsweise kann ein dielektrischer Vielschichtfilter gewählt werden, der aus mehreren Schichten von dielektrischen Materialien mit abwechselnd hohen und niedrigem Brechungsindex, z.B. TiO₂ mit n=2.1 und MgF₂ mit n =1.3 besteht. Eine andere vorteilhafte Wahl ist ein Metall-Dielektrikum-Interferenzfilter, der abwechselnd eine Metallschicht und eine dielektrische Schicht enthält und nur wenige Schichten zu umfassen braucht.

Um die Lichtreflexion an der Kathode zu unterdrücken, kann die Kathode mit einer elektrisch leitenden und lichtabsorbierenden Schicht bedeckt werden.

Die erfindungsgemäße Anzeigevorrichtung kann zusätzliche, die elektro-optischen Eigenschaften beeinflussende Einrichtungen enthalten, wie UV-Filter, Anti-Reflexbeschichtungen, als Micro-Cavities bekannte Einrichtungen sowie Farbkonversions- und Farbkorrekturfilter. Ferner ist eine hermetische Verpackung vorhanden, durch die die Anzeigevorrichtung vor Umwelteinflüssen, wie Feuchtigkeit und mechanischen Belastungen geschützt wird.

Die Anzeigevorrichtung kann z.B. als segmentierte Anzeige oder als Matrix-Display mit separat adressierten Pixeln ausgebildet sein. Die einzelnen Bildpunkte sind allein durch die Form der Elektroden leicht darzustellen, da das Polymermaterial der organischen elektrolumineszenten Komponente einen hohen Widerstand besitzt. Die Diffusion der Ladungsträger ist daher minimal, was ein Übersprechen zwischen den Bildpunkten verhindert.

Die Anzeigevorrichtung wird durch einen Elektronikteil zu einem kompletten Bildschirm ergänzt.

## Patentansprüche

1. Organische elektrolumineszente Anzeigevorrichtung, die eine Frontdektrodenkomponente, ein Gegenelektrodenkomponente, eine organische elektrolumineszente Komponente zwischen der Frontelektrodenkomponente und der Gegenelektrodenkomponente und eine optische Filterkomponente mit einem Kantenfilter zur Absorption von elektromagnetischer Strahlung mit einer Wellenlänge unterhalb einer Kantenwellenlänge λₖ und zur Transmission von elektromagnetischer Strahlung mit einer Wellenlänge oberhalb einer Kantenwellenlänge λₖ umfasst.

2. Organische elektrolumineszente Anzeigevorrichtung gemaß Anspruch 1,
**dadurch gekennzeichnet,**
**dass** die Kantenwellenlänge λₖ 500 nm beträgt.

3. Organische elektrolumineszente Anzeigevorrichtung gemäß Anspruch 1,
**dadurch gekennzeichnet,**
**dass** die elektrolumineszente Komponente ein konjugiertes Leiterpolymer vom Poly(paraphenylen)-Typ (LPPP) enthält.

4. Organische elektrolumineszente Anzeigevorrichtung gemäß Anspruch 1,
**dadurch gekennzeichnet,**
**dass** das Kantenfilter einen gelben Farbstoff oder ein gelbes Farbpigment enthält.

5. Organische elektrolumineszente Anzeigevorrichtung gemäß Anspruch 3,
**dadurch gekennzeichnet,**
**dass** der gelbe Farbstoff aus der Gruppe der gelben Farbstoffe mit dem C.I.-Index Solvent Yellow 25, Solvent Yellow 83:1, Solvent Yellow 93, Solvent Yellow 98, Solvent Yellow 114, Solvent Yellow 133, Solvent Yellow 163 und Solvent Yellow 179 ausgewählt ist.

6. Organische elektrolumineszente Anzeigevorrichtung gemäß Anspruch 3,
**dadurch gekennzeichnet,**
**dass** das gelbe Farbpigment aus der Gruppe der gelben Farbpigmente mit dem C.I. Index Pigment Yellow 13, Pigment Yellow 17, Pigment Yellow 53, Pigment Yellow 74, Pigment Yellow 83, Pigment Yellow 110, Pigment Yellow 120 und Pigment Yellow 151 ausgewählt ist.

7. Organische dektrolumineszente Anzeigevorrichtung gemäß Anspruch 1,
**dadurch gekennzeichnet,**
**dass** die optische Filterkomponente zusätzlich ein Polarisationsfilter umfasst.

8. Organische elektrolumineszente Anzeigevorrichtung gemäß Anspruch 1,
**dadurch gekennzeichnet,**
**dass** die optische Filterkomponente zusätzlich ein Interferenzfilter umfasst.

9. Organische elektrolumineszente Anzeigevorrichtung gemäß Anspruch 8,
**dadurch gekennzeichnet,**
**dass** das Interferenzfilter ein Metall-Didektrikum-Interferenzfilter ist.
